# EUROPÄISCHE PATENTSCHRIFT

(11) **EP 1 440 034 B1**
(45) Veröffentlichungstag und Bekanntmachung des Hinweises auf die Patenterteilung: **29.07.2015**
(21) Anmeldenummer: 02774296.4
(22) Anmeldetag: 04.09.2002
(51) Int. Cl.: B81B 3/00, G01N 21/00, B81C 1/00

(54) **VERFAHREN ZUM ERZEUGEN VON HOHLRÄUMEN MIT EINER OPTISCH TRANSPARENTEN WANDUNG**
METHOD FOR PRODUCING CAVITIES HAVING AN OPTICALLY TRANSPARENT WALL
PROCEDE DE PRODUCTION DE CAVITES PRESENTANT UNE PAROI TRANSPARENTE D'UN POINT DE VUE OPTIQUE

(30) Priorität: 05.10.2001 DE 10149139
(43) Veröffentlichungstag der Anmeldung: 28.07.2004
(73) Patentinhaber: ROBERT BOSCH GMBH, 70442 Stuttgart (DE)
(72) Erfinder: BENZEL, Hubert, 72124 Pliezhausen (DE); WEBER, Heribert, 72622 Nuertingen (DE); SCHAEFER, Frank, 72070 Tuebingen (DE)
(86) Internationale Anmeldenummer: PCT/DE2002/003261
(87) Internationale Veröffentlichungsnummer: WO 2003/031318

(56) Entgegenhaltungen:
- EP-A- 0 747 686
- WO-A-01/30715
- US-A- 4 890 370
- US-A- 5 582 701
- US-A- 6 136 212
- US-A- 6 162 367
- BJORKMAN H ET AL: "Diamond microchips for fast chromatography of proteins" SENSORS AND ACTUATORS B, ELSEVIER SEQUOIA S.A., LAUSANNE, CH, Bd. 79, Nr. 1, 25. September 2001 (2001-09-25), Seiten 71-77, XP004297623 ISSN: 0925-4005
- YOUNGMIN KIM ET AL: "Micromachined Fabry-Perot cavity pressure transducer with optical fiber interconnects" , MICROMACHINED DEVICES AND COMPONENTS, AUSTIN, TX, USA, 23-24 OCT. 1995 , PROCEEDINGS OF THE SPIE - THE INTERNATIONAL SOCIETY FOR OPTICAL ENGINEERING, 1995, SPIE-INT. SOC. OPT. ENG, USA, PAGE(S) 242 - 249 XP009013287 ISSN: 0277-786X das ganze Dokument

## Beschreibung

### Stand der Technik

Die Erfindung betrifft ein Verfahren zum Erzeugen von Hohlräumen mit einer optisch transparenten Wandung in einem Bauelement unter Einsatz von Mikrosystemtechnik.

Bauelemente mit derartigen Hohlräumen werden beispielsweise für optische Untersuchungen an Gasen oder Flüssigkeiten eingesetzt. In Hohlräumen mit einer optisch transparenten Wandung können auch chemische Reaktionen durchgeführt werden, die durch Lichteinwirkung, beispielsweise durch einen Laserstrahl, initiiert werden. Bauelemente mit optisch transparenten Kanälen werden auch zur optischen Füllstandskontrolle verwendet.

Es ist aus der Praxis bekannt, zur Herstellung von Bauelementen, die Hohlräume und insbesondere Kanäle mit einer optisch transparentem Wandung aufweisen, einen oder auch mehrere Glaswafer mit dem Substrat des Bauelements zu verbinden. Dieses Verfahren ist insgesamt sehr aufwendig. Soll das Bauelement für optische Untersuchungen an Flüssigkeiten oder Gasen genutzt werden, so werden häufig auch Glasfasern in das Bauelement integriert, über die Licht in den Hohlraum eingekoppelt werden kann. In diesem Fall gestaltet sich die Herstellung des Bauelements mit dem aus der Praxis bekannten Verfahren noch aufwendiger und komplexer.

Aus der US 6,162,367 ist ein Gasphasensiliziumätzverfahren bekannt, gemäß dem BrF₃ als Ätzgas eingesetzt wird. Zur Herstellung von Mikrostrukturen ist es dabei bekannt, auf eine Lage aus Polysilizium Siliziumnitrid aufzubringen, um durch Öffnungen in dem Siliziumnitrid eine Unterätzung der Siliziumnitridschicht zu erreichen, um Mikrostrukturen auszubilden.

Aus der US 5,582,701 ist ein Verfahren bekannt, bei dem ein Mikrokanal hergestellt wird, indem eine von Siliziumnitrid umschlossene Opferschicht aus Silizium über eine Öffnung heransgeätz wird.

Aus der EP 0 747 686 A1 ist bekannt eine Kavität durch Ätzen von oxidiertem porösem Silizium zu bilden.

### Vorteile der Erfindung

Mit der vorliegenden Erfindung wird ein Verfahren vorgeschlagen, mit dem sich unter Einsatz von Standardverfahren der Mikrosystemtechnik einfach und kostengünstig Hohlräume mit einer optisch transparenten Wandung in einem Bauelement erzeugen lassen. Das erfindungsgemäße Verfahren bietet dabei die Möglichkeit, auch noch weitere Funktionselemente in das Bauelement zu integrieren.

Dies wird erfindungsgemäß durch das in Anspruch 1 definierte Verfahren erreicht.

Erfindungsgemäß ist erkannt worden, dass sich Hohlräume mit einer optisch transparenten Wandung sehr einfach in Mikrosystemtechnik herstellen lassen, wenn die Wandung gleichzeitig als Ätzstoppschicht wirkt, d.h. wenn zum Herauslösen des Siliziums eine Substanz verwendet wird, deren Ätzrate hinsichtlich des Siliziums hoch ist und die gleichzeitig eine hohe Ätzselektivität zum Material der Mantelschicht aufweist. Wesentlich für das erfindungsgemäße Verfahren ist also nicht nur die Herstellung eines Siliziumbereichs, der allseitig von einer optisch transparenten Mantelschicht umgeben ist, sondern auch eine geeignete Kombination von Mantelschichtmaterial und Ätzmittel. Die Mantelschicht kann zum Herauslösen des Siliziums in vorteilhafter Weise an den Stellen geöffnet werden, an denen - aufgrund der Funktion des Bauelements - Zugangsöffnungen für den Hohlraum bzw. Kanal vorgesehen sind. Die im Rahmen des erfindungsgemäßen Verfahrens zum Einsatz kommenden Techniken ermöglichen neben der Erzeugung eines Hohlraums mit einer transparenten Wandung auch die Realisierung weiterer Funktionselemente, wie beispielsweise lichtemittierende Bereiche mit porösem Silizium, Fotodioden, mikromechanische Elemente, wie Pumpen und Ventile, eine entsprechende Ansteuer- bzw. Auswerteschaltung, etc..

Die erfindungsgemäße Mantelschicht besteht aus Siliziumoxid. Nicht unter die beanspruchte Erfindung fallen Mantelschichten aus anderen Materialien. Für das Verständnis der vorliegenden Erfindung ist es nützlich zu erwähnen, dass eine Mantelschicht aus unterschiedlichen Materialien gebildet werden kann solange sie optisch transparent ist und beim Herauslösen des umschlossenen Siliziums als Ätzstoppschicht wirkt. Als Materialien für die Mantelschicht eignen sich besonders gut Siliziumoxid und Siliziumnitrid, da sie diese beiden Kriterien hinsichtlich der meisten, üblicherweise zum Ätzen von Silizium eingesetzten Ätzmittel erfüllen und außerdem eine elektrische Isolation zum Substrat des Bauelements bilden. Die Mantelschicht kann aber beispielsweise auch ganz oder teilweise aus Borphosphorsilikatglas gebildet werden. Aus allen vorgenannten Materialien lassen sich einfach Schichten mit hinreichender Dicke erzeugen, die mit den in der Mikrosystemtechnik üblichen Verfahren strukturiert werden können, so dass sich auch einfach Öffnungen in der Mantelschicht erzeugen lassen.

Das von der Mantelschicht umschlossene Silizium kann durch nasschemisches Ätzen oder auch durch Gasphasenätzen herausgelöst werden. In der Gasphase wird vorteilhafterweise mit Xenon-Difluorid XeF₂ geätzt, da sich so sehr große Ätzraten und sehr große Unterätzungen der Mantelschicht realisieren lassen.

### Zeichnungen

Wie bereits voranstehend erwähnt, gibt es unterschiedliche Möglichkeiten, die Lehre der vorliegenden Erfindung in vorteilhafter Weise auszugestalten und weiterzubilden. Dazu wird einerseits auf die dem Patentanspruch 1 nachgeordneten Patentansprüche und andererseits auf die nachfolgende Beschreibung der Erfindung anhand der Zeichnungen verwiesen.

Die Figuren 1a bis 1e zeigen ein Bauelement in den einzelnen Phasen einer ersten Variante eines dem Verständnis nützlichen Verfahrens zur Erzeugung eines Kanals mit einer optisch transparenten Wandung.

Die Figuren 2a und 2b zeigen Varianten des in den Figuren 1a bis 1d dargestellten Verfahrensablaufs.

Die Figuren 3a bis 3d zeigen ein Bauelement in den einzelnen Phasen des erfindungsgemäßen Verfahrens zur Erzeugung eines Kanals mit einer optisch transparenten Wandung.

Fig. 4 zeigt die Aufsicht auf ein Bauelement mit einer erfindungsgemäß erzeugten Kanalstruktur.

Fig. 5 zeigt schematisch eine Anwendungsmöglichkeit für ein Bauelement mit einem erfindungsgemäß erzeugten Kanal, in dessen Wandung Kondensatorplatten integriert sind.

Die Figuren 6a und 6b zeigen die Aufsicht auf und einen Schnitt durch ein Bauelement mit einem erfindungsgemäß erzeugten Kanal, an den Glasfasern angekoppelt sind.

### Beschreibung der Ausführungsbeispiele

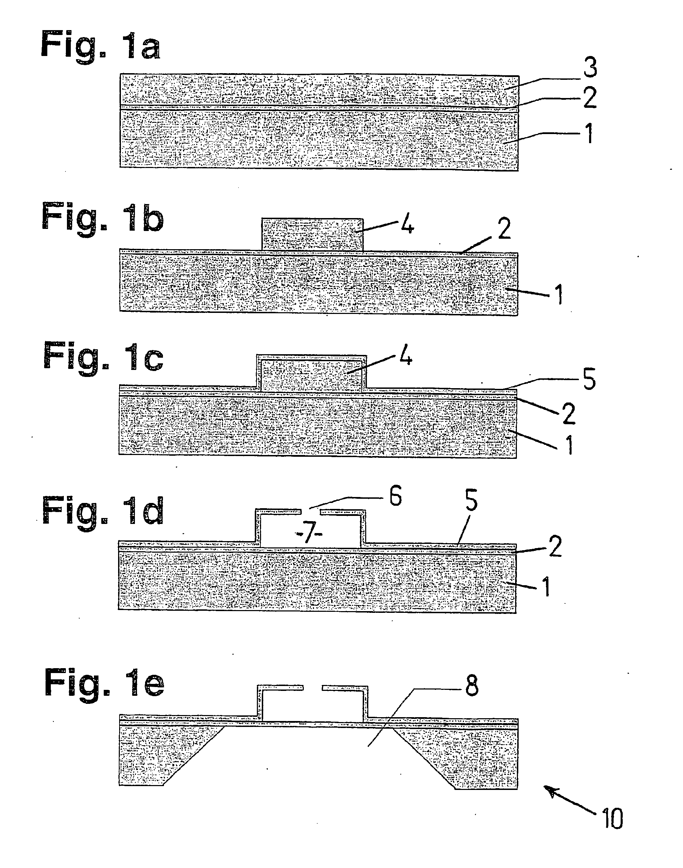

Wie bereits erwähnt, ist in den Figuren 1a bis 1e ein Bauelement 10 in den einzelnen Phasen eines dem Verständnis nützlichen Verfahrens zur Erzeugung eines Hohlraums mit einer optisch transparenten Wandung dargestellt. Das Bauelement 10 ist hier auf einem Siliziumsubstrat 1 realisiert. Im hier dargestellten Verfahren kann das Bauelement 10 aber auch auf einem anderen in der Mikrosystemtechnik verwendbaren Substrat realisiert sein.

Der in Fig. 1 a dargestellte Schichtaufbau entspricht dem eines SOI-Wafers kann aber auch ausgehend von einem das Substrat 1 bildenden Siliziumwafer realisiert werden. Dazu wird auf dem Substrat 1 eine Siliziumoxidschicht 2 erzeugt, was durch Oxidation des Siliziumwafers 1 oder auch durch Abscheidung von Siliziumoxid auf der Oberfläche des Siliziumwafers 1 erreicht werden kann. Die Siliziumoxidschicht ist optisch transparent. Danach wird auf der Siliziumoxidschicht 2 eine polykristalline Silizium-Epitaxieschicht 3 abgeschieden.

Die Silizium-Epitaxieschicht 3 wird nun so strukturiert, dass ein Siliziumbereich 4 mit der Geometrie des zu erzeugenden Hohlraums entsteht. In einer Variante des Verfahrens wird die Epitaxieschicht 3 dazu bis auf den Siliziumbereich 4 wieder komplett entfernt. Dieser Zustand ist in Fig. 1b dargestellt. Zur Strukturierung der Epitaxieschicht 3 werden Standardätztechniken, insbesondere anisotropes Plasmaätzen, eingesetzt, wobei die Siliziumoxidschicht 2 als Ätzstoppschicht dient.

Die in Fig. 1b dargestellte Struktur wird aufoxidiert oder eine Siliziumoxidschicht wird abgeschieden, d.h. auf der strukturierten Epitaxieschicht 3 bzw. auf den freiliegenden Bereichen der Siliziumoxidschicht 2 und über dem Siliziumbereich 4 wird eine zusammenhängende zweite Siliziumoxidschicht 5 erzeugt, so dass der Siliziumbereich 4 allseitig von einer Siliziumoxidschicht 2 oder 5 umgeben ist, die eine optisch transparente Mantelschicht für den Siliziumbereich 4 bilden. Dieser Zustand ist in Fig. 1c dargestellt.

Anschließend wird eine Öffnung 6 in der Mantelschicht erzeugt, über die das von der Mantelschicht umgebene Silizium herausgelöst wird, so dass ein von der optisch transparenten Mantelschicht umschlossener Hohlraum 7 entsteht. Das Herauslösen erfolgt bevorzugt in der Gasphase mit Xenon-Difluorid XeF₂, da Siliziumoxid diesem Ätzmittel gegenüber als Ätzstoppschicht wirkt und da mit diesem Ätzmittel sehr große Ätzraten und sehr große Unterätzungen realisiert werden können. In Fig. 1d ist das Bauelement 10 nach dem Herauslösen des Siliziumbereichs 4 über die Öffnung 6 in der Mantelschicht dargestellt.

Beispielsweise für optische Untersuchungen an Gasen oder Flüssigkeiten wird häufig auch die Unterseite des Hohlraums 7 freigelegt. Hierfür können Standardätztechniken eingesetzt werden, wie z.B. KOH-Ätzen oder anisotropes Plasmaätzen. Auch in diesem Fall dient die Mantelschicht des Hohlraums 7 als Ätzstoppschicht. Bei der in Fig. 1e dargestellten Variante wurde die Unterseite des Hohlraums 7 durch KOH-Ätzen freigelegt, indem von der Rückseite des Silizi umwafers 1 ausgehend im Bereich des Hohlraums 7 eine Kaverne 8 erzeugt wurde.

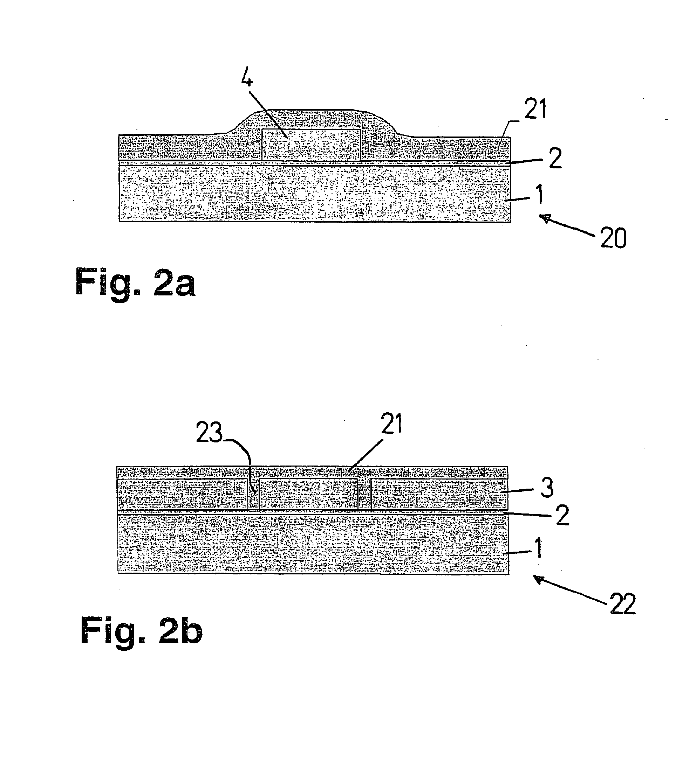

Zum Erzeugen der Öffnung 6 in der Mantelschicht wird in der Regel ein Lithographieschritt angewendet, für den die Oberfläche der zweiten optisch transparenten Ätzstoppschicht ganzflächig belackt wird. Diese Belackung erweist sich bei der in Fig. 1c dargestellten Topographie als problematisch. Die Figuren 2a und 2b zeigen zwei Varianten der in Fig.1c dargestellten Situation - Substrat 1 mit erster Siliziumoxidschicht 2, strukturierter Silizium-Epitaxieschicht 3 bzw. Siliziumbereich 4 und zweiter optisch transparenter Ätzstoppschicht über der strukturierten Epitaxieschicht 3 -, bei denen eine anschließende Belackung aufgrund der geglätteten Topographie unproblematisch ist.

Bei dem in Fig. 2a dargestellten Bauelement 20 wurde als zweite optisch transparente Schicht 21 eine dicke Siliziumoxid- oder Siliziumnitridschicht auf der strukturierten Epitaxieschicht 3 abgeschieden, was zu einer Kantenverrundung geführt hat. Zusätzlich kann hier auch noch ein Planarisierungsschritt durchgeführt werden. Anstelle von Siliziumoxid oder Siliziumnitrid kann auch Borphosphorsilikatglas (BPSG) abgeschieden werden, das ebenfalls eine optisch transparente Schicht bildet. Bei einer anschließenden Temperung verfließt das BPSG, was ebenfalls zu einer Glättung der Topographie führt.

Bei dem in Fig. 2b dargestellten Bauelement 22 wurden bei der Strukturierung der Silizium-Epitaxieschicht 3 lediglich Gräben 23 erzeugt, durch die der Siliziumbereich 4, der die Geometrie des zu erzeugenden Hohlraums aufweist, definiert wird. Die Epitaxieschicht 3 wird hier also auch außerhalb des Siliziumbereichs 4 nicht vollständig entfernt. Beim anschließenden Aufoxidieren der so erzeugten Struktur wächst unter anderem auch eine Siliziumoxidschicht auf den Seitenwänden der Gräben 23, so dass sich die Gräben 23 schließen. Dadurch wird die Topgraphie der Oberfläche insgesamt geglättet. Die zweite optisch transparente Schicht 21 kann alternativ auch durch Abscheiden von Siliziumoxid, Siliziumnitrid oder BPSG erzeugt werden, wobei die Gräben 23 ebenfalls geschlossen werden.

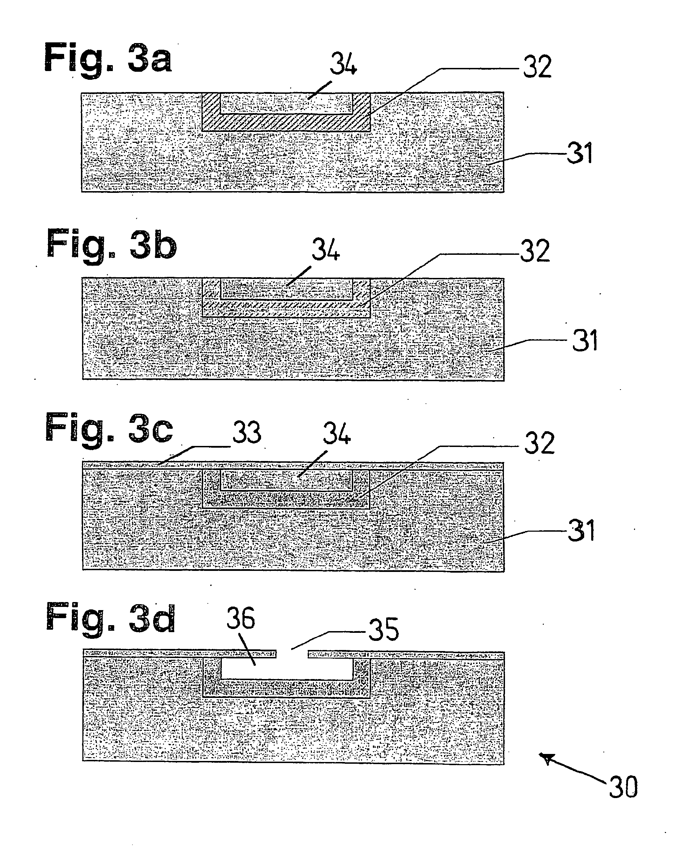

In den Figuren 3a bis 3d ist ein Bauelement 30 in den einzelnen Phasen einer Variante des erfindungsgemäßen Verfahrens zur Erzeugung eines Hohlraums mit einer optisch transparenten Wandung dargestellt. Das Bauelement 30 ist auch hier auf einem Siliziumsubstrat 31 realisiert. In dem Substrat 31 wurde mit Standardhalbleitertechniken, wie z.B. durch Dotieren, Epitaxie, und Dotieren, ein vergrabener dotierter Bereich 32 erzeugt, was in Fig. 3a dargestellt ist.

In einem p-dotierten Substrat weist der dotierte Bereich beispielsweise eine p⁺-Dotierung auf. Möglich ist auch eine n⁺-Dotierung in einem n-dotierten Substrat. Entscheidend für die Wahl der Dotierung ist, dass der dotierte Bereich 32 bei einer anschließenden Anodisierung deutlich schneller porös geätzt wird, als das den dotierten Bereich 32 umgebende Substrat 31. Durch die Anodisierung wird also ein vergrabener poröser Bereich 32 im Substrat 31 erzeugt, was in Fig. 3b dargestellt ist.

Das poröse Silizium im Bereich 32 wird bei einem nachfolgenden Oxidationsschritt aufgrund seiner großen Oberfläche sehr schnell oxidiert. Zusätzlich bildet sich auf der Oberfläche des Substrats 31 eine Siliziumoxidschicht 33, so dass ein Siliziumbereich 34 entsteht, der allseitig von einer Siliziumoxidschicht als Mantelschicht umgeben ist. Um Materialverspannungen zu vermeiden, muss die Porosität des porösen Siliziums so gewählt werden, dass die Poren durch den Materialzuwachs während der Oxidation gefüllt werden. Sowohl das Siliziumoxid im vergrabenen Bereich 32 als auch die Siliziumoxidschicht 33 sind optisch transparent. Fig. 3c zeigt das Bauelement 30, nach dem Oxidationsschritt.

Wie bei der in Verbindung mit den Figuren 1a bis 1e beschriebenen Verfahrensvariante wurde auch hier die Mantelschicht geöffnet, indem eine Öffnung 35 in der Siliziumoxidschicht 33 im Bereich des Siliziumbereichs 34, erzeugt wurde. Über diese Öffnung 35 wurde dann das von der Mantelschicht umgebene Silizium herausgeätzt. Fig. 3d zeigt das fertige Bauelement 30 mit dem so entstandenen Hohlraum 36.

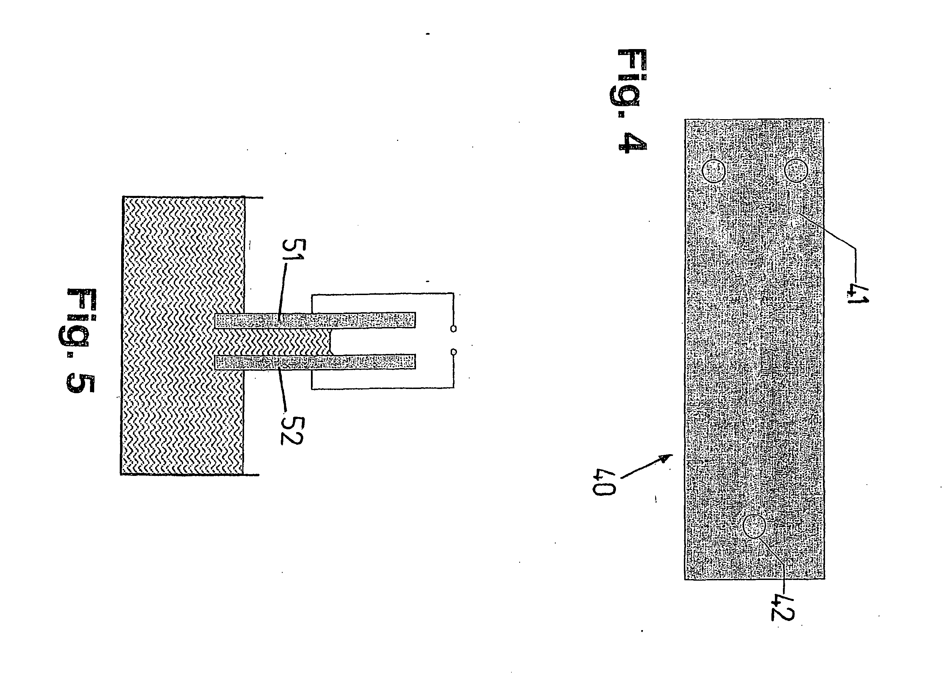

In Fig. 4 ist ein Bauelement 40 mit einer erfindungsgemäß erzeugten Kanalstruktur 41 dargestellt, die drei Zugangsöffnungen 42 umfasst. Über die Zugangsöffnungen 42 wurde das Silizium aus dem Kanalbereich herausgelöst. Die Zugangsöffnungen 42 wurden so angeordnet, dass sie auch bei der Anwendung des dargestellten Bauelements 40 als Zuführ- bzw. Austrittsöffnungen genutzt werden können.

Im Rahmen einer vorteilhaften Weiterbildung des erfindungsgemäßen Verfahrens zum Erzeugen von Kanälen mit einer optisch transparenten Wandung in einem Bauelement werden Kondensatorplatten im Bereich der Kanalwandung realisiert, so dass sich der Kanal zwischen den Kondensatorplatten befindet. Dazu kann die Kanalwandung beispielsweise mit einer entsprechenden Dotierung oder Metallisierung versehen werden. Die Kapazität des Kondensators hängt dann davon ab, welches Medium sich in dem Kanal befindet. Eine derartige Anordnung kann beispielsweise als Füllstandsanzeiger verwendet werden. Auf demselben Prinzip beruht die Realisierung einer Schranke, bei der nur ein vergleichsweise kleiner Kanalabschnitt mit Kondensatorplatten versehen ist. Hier ändert sich die Kapazität der Anordnung, wenn ein Medium den mit Kondensatorplatten versehenen Kanalabschnitt erreicht.

Ein mit Kondensatorplatten ausgestatteter Kanal kann auch zum Ansaugen von Dielektrika eingesetzt werden. Ein derartiger Aufbau ist schematisch in Fig. 5 dargestellt. Mit 51 und 52 sind hier die in die Kanalwandung integrierten Kondensatorplatten bezeichnet. Durch Anlegen einer Spannung werden Dielektrika, wie beispielsweise Wasser, bis zu einer gewissen Höhe zwischen die Kondensatorplatten 51 und 52 gesaugt, da sich dadurch die Energiedichte des elektrischen Feldes zwischen den Kondensatorplatten 51 und 52 erhöht. Eine derartige Anordnung kann beispielsweise als Dosiervorrichtung verwendet werden.

Optional kann im Bereich eines solchen Kanals auch eine Heizstruktur, z.B. aus Platin, erzeugt werden, um das Medium im Kanal zu beheizen. Eine derartige Struktur kann auch zur Temperaturmessung des Mediums verwendet werden.

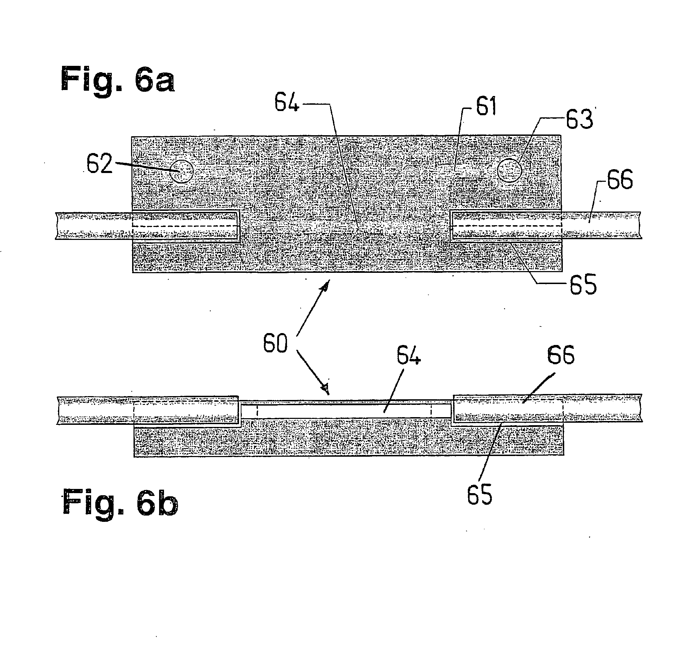

In einer anderen vorteilhaften Weiterbildung des erfindungsgemäßen Verfahrens können neben dem Hohlraum bzw. Kanal mit Standardätztechniken Ausnehmungen für Glasfasern erzeugt werden, um Licht in den Hohlraum bzw. Kanal einzukoppeln. So lassen sich beispielsweise durch anisotropes Ätzen mit KOH sogenannte V-Gruben erzeugen, die sehr exakt positionierbar und dimensionierbar sind. In diesen Strukturen können Glasfasern sehr genau justiert werden, was nicht nur für optische Untersuchungen, wie die Transmissionsspektroskopie, wichtig ist, sondern beispielsweise auch zum Einkoppeln eines Laserstrahls, mit dem photochemische Reaktionen initiiert werden sollen. In den Figuren 6a und 6b ist ein Bauelement 60 in Aufsicht (Fig. 6a) und im Schnitt (Fig. 6b) dargestellt, das sich insbesondere für Transmissionsuntersuchungen eignet. Der Kanal 61 weist eine im wesentlichen U-förmige Führung auf. An dem einen Ende des Kanals 61 befindet sich eine Zufuhröffnung 62, über die dem Kanal 61 ein Medium zugeführt werden kann, das dann über eine Austrittsöffnung 63 wieder aus dem Kanal 61 austreten kann. Der Querschenkel der U-Form des Kanals 61 bildet eine optische Strecke 64. In Verlängerung der optischen Strecke 64 sind V-Gruben 65 im Bauelement 60 ausgebildet, in denen jeweils eine Glasfaser 66 zum Einkoppeln von Licht in die optische Strecke 64 angeordnet sind.

Schließlich sei noch darauf hingewiesen, dass in den freien Bereichen eines mit dem erfindungsgemäßen Verfahren gestalteten Bauelements weitere Funktionselemente realisiert werden können, wie z.B. lichtemittierende Bereiche mit porösem Silizium, Fotodioden, mikromechanische Pumpen und Ventile und auch eine entsprechende Ansteuer- und Auswerteschaltung.

Zusammenfassend kann festgestellt werden, dass sich mit dem erfindungsgemäßen Verfahren Bauelemente mit Hohlräumen und insbesondere Kanälen herstellen lassen, deren Wandung ganz oder zumindest bereichsweise optisch transparent ist. Dazu werden auf einem Substrat Siliziumbereiche geschaffen, die ganzflächig von einem optisch transparenten und als Ätzstopp wirkenden Material, Siliziumoxid, ummantelt sind. Die Siliziumbereiche entsprechen dabei der Form der herzustellenden Hohlräume. In der Position der Zugangsöffnungen der Hohlräume wird die Mantelschicht geöffnet. Durch nasschemisches Ätzen oder durch Ätzen mittels Gasen wird das Silizium herausgelöst. Bevorzugt wird hierbei mit Xenon-Difluorid XeF₂ geätzt. Dieses Gas ätzt Silizium mit hoher Ätzrate und hoher Ätzselektivität zu Siliziumoxid und Siliziumnitrid. Zudem lassen sich damit sehr große Unterätzungen bis zu mehreren Millimetern realisieren, so dass dieses Gas sehr gut dazu geeignet ist, von den Zugangsöffnungen eines Hohlraums und insbesondere eines Kanals ausgehend das umschlossene Silizium herauszulösen.

## Patentansprüche

1. Verfahren zum Erzeugen von Hohlräumen (36) mit einer optisch transparenten Wandung in einem Bauelement (30) unter Einsatz von Mikrosystemtechnik wobei das Bauelement (30) auf einem Siliziumsubstrat (31) realisiert ist, wobei ein Siliziumbereich (34) erzeugt wird, der allseitig von mindestens einer optisch transparenten Mantelschicht umgeben ist, indem ein vergrabener dotierter Bereich (32) im Siliziumsubstrat (31) erzeugt wird, eine Anodisierung durchgeführt wird, bei der aus dem vergrabenen dotierten Bereich (32) ein vergrabener poröser Bereich (32) entsteht, und indem eine Oxidation durchgeführt wird, bei der das poröse Silizium in dem vergrabenen Bereich (32) oxidiert wird und sich eine Siliziumoxidschicht (33) auf der Oberfläche des Siliziumsubstrats (31) bildet, so dass der besagte Siliziumbereich (34) zwischen dem oxidierten porösen Silizium und der Siliziumoxidschicht liegt und allseitig von einer Siliziumoxid-Mantelschicht umgeben ist, wobei mindestens eine Öffnung (35) in der Mantelschicht erzeugt wird, wobei das von der Mantelschicht umgebene Silizium über die Öffnung in der Mantelschicht herausgelöst wird und wobei die Mantelschicht als Ätzstoppschicht wirkt.

2. Verfahren nach Anspruch 1, **dadurch gekennzeichnet, dass** eine SiliziumoxidSchicht, eine Siliziumnitrid-Schicht oder eine Borphosphorsilikatglas-Schicht als Mantelschicht dient.

3. Verfahren nach einem der Ansprüche 1 oder 2, **dadurch gekennzeichnet, dass** das Silizium durch nasschemisches Ätzen herausgelöst wird.

4. Verfahren nach einem der Ansprüche 1 oder 2, **dadurch gekennzeichnet, dass** das Silizium in der Gasphase vorzugsweise mit Xenon-Difluorid XeF₂ herausgeätzt wird.

5. Verfahren nach einem der vorhergehenden Ansprüche, **dadurch gekennzeichnet, dass** die Mantelschicht auch als Ätzstoppschicht beim Freilegen der Wandung von der Außenseite des Hohlraums dient.

6. Verfahren zum Erzeugen von Kanälen mit einer optisch transparenten Wandung in einem Bauelement nach einem der vorhergehenden Ansprüche, **dadurch gekennzeichnet, dass** in der Wandung Kondensatorplatten realisiert werden.

7. Verfahren nach Anspruch 6, **dadurch gekennzeichnet, dass** die Kondensatorplatten durch Dotierung oder Metallisierung der Wandung realisiert werden.

8. Verfahren zum Erzeugen von Kanälen mit einer optisch transparenten Wandung in einem Bauelement nach einem der vorhergehenden Ansprüche, **dadurch gekennzeichnet, dass** eine Heizstruktur zum Beheizen eines im Kanal geführten Mediums erzeugt wird.

9. Verfahren zum Erzeugen von Kanälen mit einer optisch transparenten Wandung in einem Bauelement nach einem der vorhergehenden Ansprüche, **dadurch gekennzeichnet, dass** im Bauelement (60) Ausnehmungen (65) für Glasfasern (66) erzeugt werden, über die Licht in den Kanal (61) eingekoppelt werden kann.

10. Verwendung eines Verfahrens nach einem der Ansprüche nach einem der vorhergehenden Ansprüche zur Herstellung eines Füllstandsanzeigers, einer Schranke oder einer Dosiervorrichtung für dielektrische Flüssigkeiten.

## Claims

1. Method for producing cavities (36) having an optically transparent wall in a component (30) using microsystems engineering, wherein the component (30) is realized on a silicon substrate (31), wherein a silicon region (34) is produced, which is surrounded on all sides by at least one optically transparent cladding layer by virtue of a buried doped region (32) being produced in the silicon substrate (31), an anodization being carried out, in the course of which a buried porous region (32) arises from the buried doped region (32), and by virtue of an oxidation being carried out, in the course of which the porous silicon in the buried region (32) is oxidized and a silicon oxide layer (33) forms on the surface of the silicon substrate (31), such that said silicon region (34) lies between the oxidized porous silicon and the silicon oxide layer and is surrounded on all sides by a silicon oxide cladding layer, wherein at least one opening (35) is produced in the cladding layer, wherein the silicon surrounded by the cladding layer is removed via the opening in the cladding layer, and wherein the cladding layer acts as an etch stop layer.

2. Method according to Claim 1, **characterized in that** a silicon oxide layer, a silicon nitride layer or a borophosphosilicate glass layer serves as the cladding layer.

3. Method according to either of Claims 1 and 2, **characterized in that** the silicon is removed by wet-chemical etching.

4. Method according to either of Claims 1 and 2, **characterized in that** the silicon is etched out in the gas phase preferably using xenon difluoride XeF₂.

5. Method according to any of the preceding claims, **characterized in that** the cladding layer also serves as an etch stop layer during the process of exposing the wall from the outer side of the cavity.

6. Method for producing channels having an optically transparent wall in a component according to any of the preceding claims, **characterized in that** capacitor plates are realized in the wall.

7. Method according to Claim 6, **characterized in that** the capacitor plates are realized by doping or metallization of the wall.

8. Method for producing channels having an optically transparent wall in a component according to any of the preceding claims, **characterized in that** a heating structure for heating a medium guided in the channel is produced.

9. Method for producing channels having an optically transparent wall in a component according to any of the preceding claims, **characterized in that** cutouts (65) for optical fibres (66) via which light can be coupled into the channel (61) are produced in the component (60).

10. Use of a method according to any of the preceding claims for producing a filling level indicator, a barrier or a metering device for dielectric liquids.

## Revendications

1. Procédé de production de cavités (36) présentant une paroi optiquement transparente dans un composant (30) par utilisation de technique de microsystème, dans lequel le composant (30) est réalisé sur un substrat de silicium (31), dans lequel on produit une zone de silicium (34) qui est entourée de tous les côtés par au moins une couche d'enveloppe optiquement transparente, par le fait que l'on produit une zone creusée dopée (32) dans le substrat de silicium (31), on effectue une anodisation par laquelle il apparaît à partir de la zone creusée dopée (32) une zone creusée poreuse (32), et par le fait que l'on effectue une oxydation, par laquelle le silicium poreux dans la zone creusée (32) est oxydé et il se forme une couche d'oxyde de silicium (33) sur la surface du substrat de silicium (31), de telle manière que ladite zone de silicium (34) se trouve entre le silicium oxydé poreux et la couche d'oxyde de silicium et soit entourée de tous les côtés par une couche d'enveloppe d'oxyde de silicium, dans lequel on produit au moins une ouverture (35) dans la couche d'enveloppe, dans lequel on enlève par dissolution le silicium entouré par la couche d'enveloppe via l'ouverture dans la couche d'enveloppe et dans lequel la couche d'enveloppe agit comme couche d'arrêt de corrosion.

2. Procédé selon la revendication 1, **caractérisé en ce qu'**une couche d'oxyde de silicium, une couche de nitrure de silicium ou une couche de verre boro-phosphor-silicaté sert de couche d'enveloppe.

3. Procédé selon l'une des revendications 1 ou 2, **caractérisé en ce que** l'on enlève le silicium par dissolution par attaque chimique humide.

4. Procédé selon l'une des revendications 1 ou 2, **caractérisé en ce que** l'on corrode le silicium en phase gazeuse de préférence avec du difluorure de xénon XeF₂.

5. Procédé selon l'une quelconque des revendications précédentes, **caractérisé en ce que** la couche d'enveloppe sert également de couche d'arrêt de corrosion lors du dégarnissage de la paroi du côté extérieur de la cavité.

6. Procédé de production de canaux présentant une paroi optiquement transparente dans un composant selon l'une quelconque des revendications précédentes, **caractérisé en ce que** l'on réalise des plaques de condensateur dans la paroi.

7. Procédé selon la revendication 6, **caractérisé en ce que** l'on réalise les plaques de condensateur par dopage ou métallisation de la paroi.

8. Procédé de production de canaux présentant une paroi optiquement transparente dans un composant selon l'une quelconque des revendications précédentes, **caractérisé en ce que** l'on produit une structure de chauffage pour le chauffage d'un fluide transporté dans le canal.

9. Procédé de production de canaux présentant une paroi optiquement transparente dans un composant selon l'une quelconque des revendications précédentes, **caractérisé en ce que** l'on produit dans le composant (60) des évidements (65) pour des fibres de verre (66), par lesquelles une lumière peut être injectée dans le canal (61).

10. Utilisation d'un procédé selon l'une quelconque des revendications précédentes pour la fabrication d'un indicateur de niveau, d'une barrière lumineuse ou d'un dispositif de dosage pour des liquides diélectriques.
